# EUROPEAN PATENT APPLICATION

(11) **EP 2 749 893 A1**
(43) Date of publication of application: **02.07.2014**
(21) Application number: 12199804.1
(22) Date of filing: 31.12.2012
(51) Int. Cl.: G01R 29/26, G01R 31/26, G01R 31/317

(54) **Low frequency noise measurement**

(71) Applicant: IMEC, 3001 Leuven (BE); Sony Corporation, Tokyo 108-0075 (JP)
(72) Inventor: Van der Plas, Geert, 3001 Leuven (BE); Sawada, Ken, 3001 Leuven (BE); Borremans, Jonathan, 3001 Leuven (BE)
(74) Representative: Sarlet, Steven Renaat Irène

(57) **Abstract**

System for low frequency noise measurement of a device under test on a wafer is provided. The system comprises on the same wafer a reference signal generator connectable to an input of said device under test and provided for generating a predetermined low frequency reference signal. The system further includes a digitizing means connectable to an output of said device under test and provided for digitizing an output signal of the device under test, comparing low frequency noise of said device under test and the predetermined reference signal. The predetermined reference signal is dominant with respect to the low frequency noise of said device under test.

## Description

### TECHNICAL FIELD

The present disclosure relates to measurement of low frequency noise of one or more devices under test on a wafer. The present disclosure further relates to a production process using such a measurement.

### BACKGROUND ART

Generally, noise in an electronic system is understood to mean any undesired electrical signal. The noise may comprise of the undesired signals at different frequencies. One type of noise commonly found in electronic systems is low frequency noise, also known as 1/f noise, flicker noise or pink noise. The low frequency noise may be due to a defect in manufacturing, parasitic effects, or due to variations in physical properties of materials of the electronic devices at operating conditions (like temperature, humidity, aging, etc.). Reducing and/or minimizing the low frequency noise is desirable so that the electronic system may work as per requirements. This may require an initial step of noise measurement so that an accurate analysis can be done.

Low frequency noise measurement systems currently known in the art suffer from one or more deficiencies. For example, currently available stand alone systems for the low frequency noise measurement are expensive and employ complex circuitry. Further, the existing systems consume a long time for the measurement of the low frequency noise. Further, the existing systems are off-chip measurement systems, which may introduce errors in the measurement of the low frequency noise of on-chip electronic devices.

United States patent US7915905 to Haroun et al. discloses an on-chip monitor circuit for monitoring flicker noise independently of temperature and process variations. However, the flicker noise measurement by Haroun provides only a relative value for the flicker noise.

### SUMMARY OF THE DISCLOSURE

It is an aim of the present disclosure to provide a system with which an absolute value of low frequency noise of a device under test can be determined using on chip measurement circuitry. This aim is achieved according to the disclosure with the system of claim 1.

It is another aim of the present disclosure to provide a production method which makes efficient use of such a system. This other aim is achieved according to the disclosure with the method of the second independent claim.

An aspect of the present disclosure provides a system that includes a reference signal generator connectable to an input of a device under test on a wafer. The reference signal generator is provided for generating a predetermined low frequency reference signal. The system further includes a digitizing means disposed on the same wafer and connectable to an output of said device under test. The digitizing means is provided for digitizing an output signal of the device under test. The output signal comprises the low frequency noise of said device under test and the predetermined reference signal, the predetermined reference signal being dominant with respect to the low frequency noise of said device under test. Said reference signal generator may also be disposed on the same wafer, though this is not essential.

The present disclosure provides a system which can measure an absolute value of the low frequency noise of a device under test. Further, the measurement is achieved on-chip. Further, there is no need of expensive equipment for the measurement of the low frequency noise. The present system further provides a better resolution of the low frequency noise. Further, an advantage of the digital output is that the digital output can be read easily and in a massively parallel set-up by an off-chip test I/O system.

Another aspect of the present disclosure provides a method comprising determining noise characteristics of low frequency noise of a device under test on a wafer using a system proposed by the present disclosure. The method further comprises providing feedback to adjust process condition based, at least in part, on the noise characteristics.

In an embodiment, the system includes a control loop. The control loop is connectable between an output of the digitizing means and an input of the device under test. The control loop includes a control means configured for controlling a component of the device under test on the basis of the digitized output signal to compensate the low frequency noise.

In one embodiment, the digitizing means includes a phase detector and an up/down counter.

In one embodiment, the control loop includes a digital-to-analog converter. The control loop of the system provides a cheap and simple mechanism for measuring the absolute value of the low frequency noise.

In one embodiment, the system may measure the low frequency noise of a pair of devices under test using a comparison mechanism. The system includes a first branch having a first device under test connected between the reference signal generator and the digitizing means. The system further includes a second branch having a second device under test connected between the reference signal generator and the digitizing means. The system includes an adjustable component connected between the first and second branches and having an adjustable electrical property such that a ratio of low frequency noise of the first device under test with respect to the second device under test can be adjusted. In one embodiment, the adjustable component is a capacitor. The adjustable component allows to determine whether the low frequency noise component due to the pair of devices under test is dominant over noise component due to other devices in the measurement system. Further, it allows to determine the contribution of the low frequency noise component due to the pair of devices under test in the overall noise measured by the system.

In one embodiment, the system includes a plurality of device under test (DUT) pairs, each of the plurality of DUT pairs having said first and second branches and a component connected between the first and second branches. The component has a predefined electrical property which is intentionally different for each of the plurality of DUT pairs.

The present disclosure provides various embodiments, systems, methods and articles of manufacture for measurement of an absolute value of low frequency noise due to a DUT. The measurement is performed on chip requiring a minimal or no external system for the purpose. According to one embodiment, the absolute value of the low frequency noise (LFN) is measured by digitizing a reference signal, also called calibration signal. The calibration signal along with the LFN is digitized. The digitized signal is further processed to measure the absolute value of the LFN. The LFN generated by the DUT is an analog signal. The analog signal is converted into a digital signal by the digitizing means. In one embodiment, the analog signal is converted into the digital signal using a first order difference modulator analog to digital converter (ADC). In one embodiment the ADC is implemented using a comparator, an integrator, and a digital to analog converter (DAC).

### BRIEF DESCRIPTION OF THE DRAWINGS

The disclosure will be further elucidated by means of the following description and the appended figures.
Figure 1 shows a system for measuring low frequency noise due to a device under test, according to an embodiment of the present disclosure.
Figure 2 shows a system for measuring low frequency phase noise due to a device under test, where the device under test is a delay stage, according to an embodiment of the present disclosure.
Figure 3 shows, in a graphical manner, various outputs of the system of Figure 2, according to an embodiment of the present disclosure.
Figure 4 shows a system for measuring low frequency flicker noise due to a device under test, where the device under test is a delay stage, according to an embodiment of the present disclosure.
Figure 5 shows a system for measuring low frequency noise due to a device under test pair, where the device under test is an integrating amplifier, according to an embodiment of the present disclosure.
Figure 6 shows an implementation of a first stage of the system of figure 5, according to an embodiment of the present disclosure.
Figure 7 shows an implementation of a first stage of a system for measurement of low frequency noise of a single DUT, according to an embodiment of the present disclosure.
Figure 8 shows implementation of a first stage of a system for identifying contribution of the low frequency noise due to a pairs of devices under test, according to an embodiment of the present disclosure.
Figure 9 shows implementations of first stages of a system for measuring low frequency noise due to a plurality of pairs of devices under test, according to an embodiment of the present disclosure.
Figure 10 shows a system for measuring low frequency noise due to a plurality of pairs of devices under test sharing common measurement circuitry, according to an embodiment of the present disclosure.
Figure 11 shows a method for measuring low frequency noise due to a device under test, according to an embodiment of the present disclosure.

### DETAILED DESCRIPTION OF PREFERRED EMBODIMENTS

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemplary manners in which the disclosure may be implemented rather than as limiting the scope of the disclosure.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

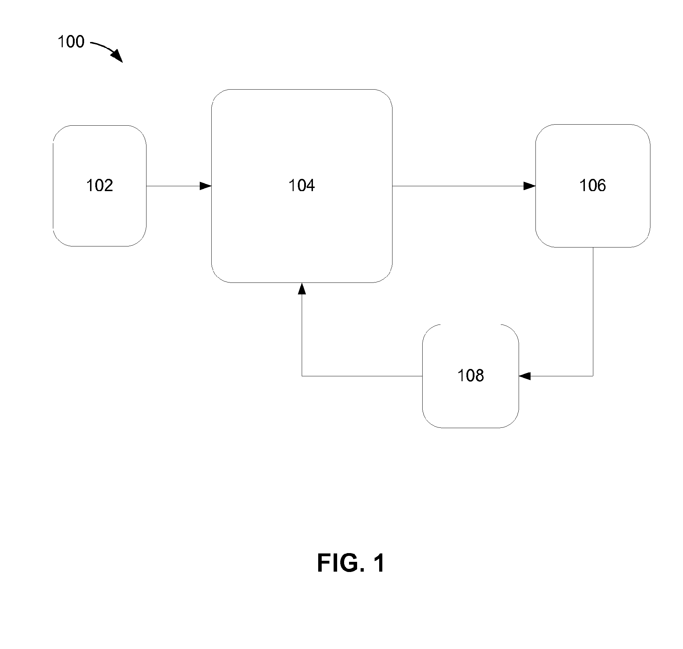

Referring to figure 1, a system 100 measures an absolute value of low frequency noise of a device under test (DUT). The system 100 includes a reference signal generator 102, a DUT 104, and a digitizing means 106. In an embodiment, the system 100 may further include a control loop 108. The DUT 104 is disposed on a wafer. The DUT 104 may be a discrete time integrating amplifier, a delay stage, a voltage controlled oscillator (VCO) with tail current and the like. The digitizing means 106 and the control loop 108 are also disposed on the same wafer. The reference signal generator 102 is shown to be also disposed on the same wafer, but this is not essential. Characteristics of the DUT 104 may differ from desired characteristics during operation. The variation might be due to a defect, parasitic effects, or change in one or more physical or electrical properties of the DUT 104. The defect in the DUT 104 may include, but not limited to, a manufacturing defect and an operational defect. The defect in the DUT 104 may result in noise which interferes with a normal operation of the DUT 104. For example, the noise may include low frequency noise (LFN). Low frequency noise increases as the size of the DUT 104 decreases. The system 100 measures an absolute value of the low frequency noise (LFN) of the DUT 104. The measurement of the LFN of the DUT 104 enables improving a production process of the DUT 104. Appropriate alterations in the production process may be adopted to decrease the LFN of the DUT 104. Alternatively, a compensatory mechanism may be adopted to reduce the LFN of the DUT 104.

The reference signal generator 102 generates a reference signal. In an embodiment, the reference signal is a low frequency single tone signal. An amplitude and frequency of the reference signal are predetermined to be dominant over the LFN and to be detectable at the output. The reference signal is fed to an input of the DUT 104. The DUT 104 will generate an output signal according to a normal operation of the DUT 104. The output signal includes the LFN signal and the reference signal. The digitizing means 106 converts the output signal into a digital signal. In one embodiment, the digitizing means 106 may be a first order difference modulator analog to digital converter (ADC). The first order difference modulator ADC is implemented using a comparator, an integrator, and a digital to analog converter (DAC). In an embodiment, the digitizing means 106 may include a phase detector and an up/down counter. Thus, the digitizing means 106 converts the LFN signal and the reference signal into corresponding digital signals. The digitized output signal may be measured in reference with the reference signal, the amplitude and the frequency of which are known, using an on-chip equipment and/or an off-chip equipment (not shown) to provide the absolute value of the LFN. An advantage of the digital output is that the digital output can be read easily and in a massively parallel set-up by an off-chip test I/O systems.

The control loop 108 acts as a feedback loop enabling measurement of the absolute value of the LFN. In one embodiment, the control loop 108 may include a digital to analog converter (DAC).

In digital domain an absolute value of the LFN is typically not known. The system 100 allows to measure an absolute value of the LFN is measured. Application of the reference signal in a low frequency band of interest with known amplitude and at a known frequency to the DUT enables the system 100 to be calibrated for measuring the absolute value of the LFN. The LFN noise of the DUT gets superimposed on the reference signal and gets converted to the digital domain. The output in the digital domain contains the digital representation of the reference signal, which has known characteristics, and the unknown LFN component. The absolute value of the LFN of the DUT can then be easily measured from the digital output by using the known characteristics of the reference signal.

In an embodiment, a frequency of the reference signal may be chosen such that the reference signal frequency does not overlap with the range of frequencies of the LFN, or with at least the range of frequencies at which the LFN characteristics are to be measured (hereinafter, frequency range of interest). In an example implementation, an FFT bin corresponding to the reference signal frequency is removed from LFN measurement. Further, the reference signal frequency may be chosen such that the reference signal frequency is close enough to the frequency range of interest so that it accurately predicts what is happening at a measured frequency or measured frequencies. Further, amplitude of the reference signal is set such that the reference signal dominates energy in the FFT bin corresponding to the reference signal frequency. In an embodiment, the amplitude of the reference signal is at least 10dB higher than the amplitude of the LFN. In a preferred embodiment, the amplitude of the reference signal is 20dB higher than the amplitude of the LFN. Further, the amplitude of the reference signal is kept within a range of the digitizing means 106. Further, it may be desirable that the reference signal is spectrally pure, for example, allowing at most 1 Hz power spreading in one second measurement time. This is because, in long time length measurements, if the reference signal is not spectrally pure, its energy may spread across multiple frequencies; thereby, hiding more frequencies from measurement and lowering the observed power versus the LFN noise. In an example implementation, the reference signal generator 102 may generate the reference signal with at most 1 Hz power spreading in one second measurement.

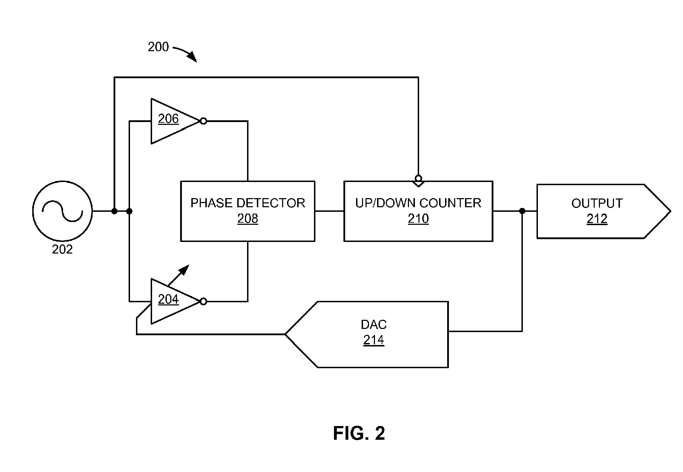

Figure 2 illustrates a system 200 for measuring low frequency noise of delay stages, in accordance with an embodiment of the present disclosure. In this case, the delay stages are the DUTs for which the low frequency noise is measured. The delay stages may be implemented by inverters. The system 200 includes a ring oscillator 202, an inverter 204, an inverter 206, a phase detector 208, and an up/down counter 210. In an embodiment, the ring oscillator 202 generates the reference signal at a predetermined low frequency and amplitude, oscillating between two voltage levels, representing high and low levels. The output of the ring oscillator 202, i.e. the reference signal, is fed to the inverter 204 and the inverter 206. The inverters 204 and 206 delay the reference signal. The inverters 204 and 206 have nominally equal delay times, T_{A} and T_{B}, respectively. The low frequency noise of the inverters 204 and 206 gets superimposed on the delayed reference signal at the outputs of the inverters 204 and 206. The output signals of the invertors 204 and 206 are fed to the phase detector 208. The phase detector 208 generates an output (for example, a voltage signal) based on phase difference between the two signal inputs.

As the reference signal travels through the inverters 204 and 206, the reference signal causes two edges at the input of the phase detector 208. The phase detector 208 detects which edge appears first. Since delays of the inverters 204 and 206 are equal, only noise (phase noise in this example) will cause one edge to be earlier than the other. Hence, the phase detector output ('1' or '0') is a measure for the noise. If the LFN is present, random walk phenomena will occur and the phase detector 208 will detect long times of '1' and long times of '0'.

The output of the phase detector 208 is fed to the up/down counter 210. The up/down counter 210 increments or decrements a counter value depending upon whether the output of the phase detector 208 is "1" or "0" (or vice versa), respectively. Further, as the reference signal acts as a clock input of the up/down counter 210, the up/down counter 210 changes the counter value at an edge (at a falling edge in this example) of the reference signal. Output of the up/down counter 210 is obtained as output 212 of the system 200. The output 212 is measured in reference to the known reference signal to obtain the absolute value of the LFN of the inverters 204 and 206.

To improve resolution of the system 200, the system 200 may further include a digital to analog converter (DAC) 214 coupled between the output of the up/down counter 210 and one of the inverters 204 and 206 (to the inverter 204 in an example implementation illustrated in Figure 2). The output of the DAC 214 adjusts the delay time of the inverter 204. Without the DAC 214, the long times of '1' and long times of '0' at the output of the phase detector 208 may allow to measure the LFN only at very low, distorted resolution. Feeding back the output of the phase detector 208 using the up/down counter 210 and DAC 214 enables the system 200 to track the LFN, resulting in a better resolution of the LFN measurement.

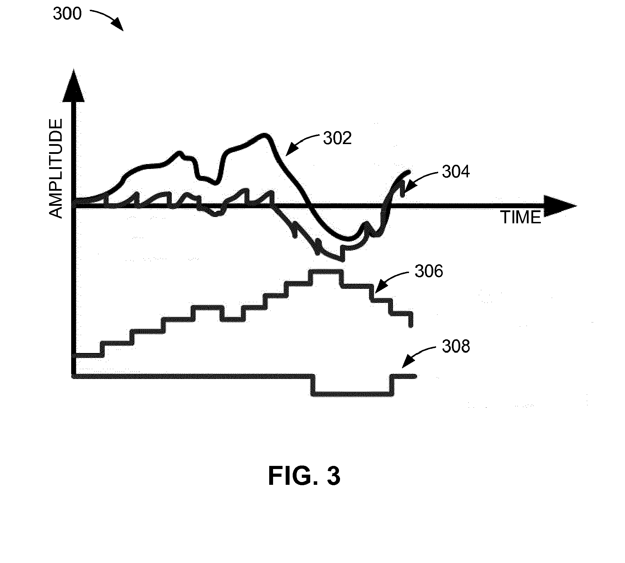

This may be further illustrated by example waveforms shown in Figure 3. Referring to figure 3, curve 302 represents phase noise (exhibited as a phase difference between the inverter 204 and 206) plotted in amplitude versus time graph. The phase detector 206 detects the phase noise and the output of the phase detector 208 is a sequence of long "1" and "0", shown by curve 308. It can be seen from curve 308 that the resolution is low. On the other hand, when the phase detector 208 output is fed back to the inverter 204 via the up/down counter 210 and the DAC 214, delay-corrected phase noise signal results (represented by curve 304). The phase detector 208 tracks this signal and corresponding output signal is represented by curve 306. It is clearly apparent that with the feedback loop, the resolution of the LFN measurement system 200 is improved.

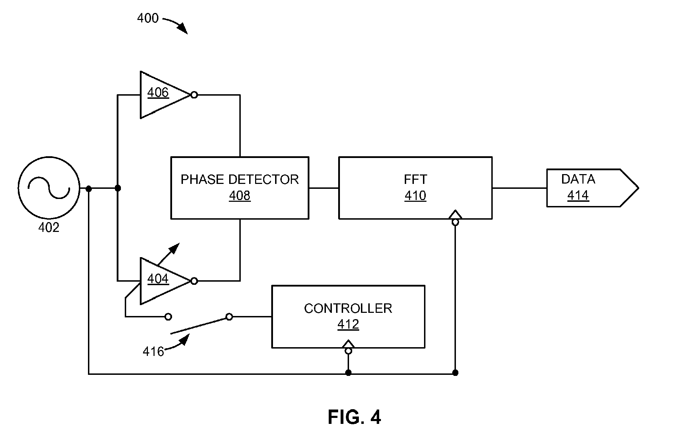

Figure 4 illustrates a system 400 for measuring low frequency noise of delay stages, in accordance with an embodiment of the present disclosure. In the system 400, instead of measuring the phase noise as in the system 200, flicker noise of the delay stages, implemented using inverters, is measured in a ring oscillator-like setup.

The system 400 includes a ring oscillator 402, an inverter 404, an inverter 406, a phase detector 408, a Fast Fourier Transform (FFT) unit 410, and a controller 412. In an embodiment, the ring oscillator 402 outputs a reference signal having known frequency and amplitude. The output of the ring oscillator 402, i.e. the reference signal, is fed to the inverter 404 and the inverter 406. The inverters 404 and 406 delay the reference signal with respective delays. The low frequency noise due to the inverters 404 and 406 gets superimposed on the delayed reference signal. The output signals of the inverters are fed to the phase detector 408. The phase detector 408 generates an output signal based on the difference in phase between two signal inputs from the inverters 404 and 406. The system 400 further includes the controller 412 coupled to one of the inverters 404 and 406 through a switch 416. In the example implementation illustrated in Figure 4, the controller 412 is coupled to the inverter 404. During operation of the system 400, initially the switch 416 is closed; which closes a control loop containing the controller 412. The controller 412 sets average delay of the inverters 404 and 406 as equal. The reference signal acts as a clock signal to the controller 412, and the FFT unit 410. The switch 416 is switched to OFF position once the delays of the inverters 404 and 406 are equalized. In this mode, the phase detector 408 measures the time difference between the output of the inverters 404 and 406. As the delays of the inverters 404 and 406 are made equal, the time difference is due to the flicker noise of the inverters 404 and 406. Therefore, the output signal of the phase detector 408 can be used to measure the LFN. For example, discrete Fourier transform (DFT) of the phase detector 408 output can be taken to determine flicker noise component at the desired frequency bin(s). In an example implementation shown in Figure 4, the FFT unit 410 takes the DFT. In another embodiment, the phase detector 408 output may be filtered using a low pass filter to enhance the LFN component in the frequency range of interest and the low pass filtered signal may be measured to give the absolute value of the LFN.

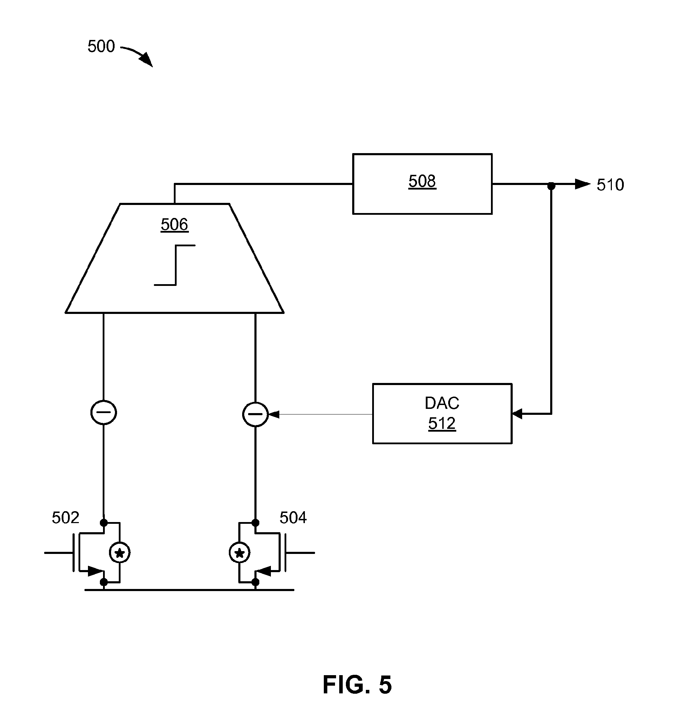

Figure 5 illustrates system 500 for measuring the low frequency noise of a pair of devices under test, where the devices under test are discrete integrating amplifiers, in accordance with an embodiment of the present disclosure. In this example, the system 500 measures the low frequency noise of the pair of devices under test using a first order delta modulator as the digitizing means. The system 500 includes the pair DUTs 502 and 504, a comparator 506 and an integrator 508. A reference signal generator (not shown) gives the reference signal to the pair of DUTs 502 and 504. To convert low frequency noise accurately a stable low frequency system is preferred with long time constants because the LFN to be measured is at very low frequencies, for example at 100 Hz. According to an embodiment of the present disclosure, to exhibit such long time constants, the system 500 may be realized using an up/down counter as the integrator 508 and a digital feedback loop having a digital to analog converter (DAC) 512. The only analog components in the system 500 are the comparator 506 and DAC 512. The output 510 of the system 500 is a data stream containing the low frequency noise of the pair of DUTs and the reference signal.

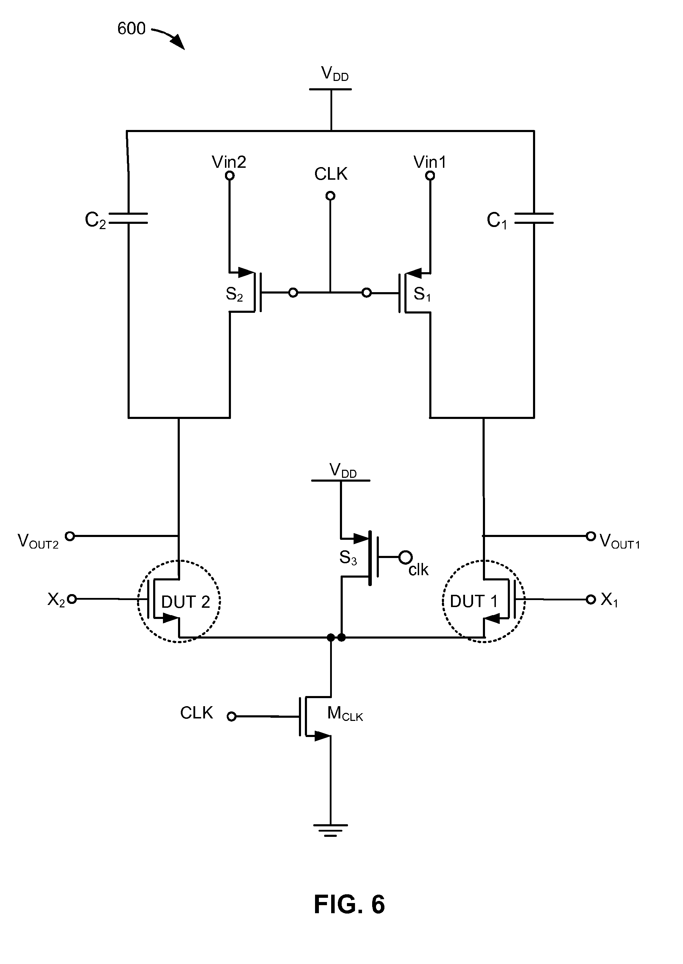

Figure 6 shows a circuit diagram for implementing a first stage of the system 500, in accordance with an embodiment of the present disclosure. As shown, the first stage 600 includes two branches. For example, a first branch of the first stage 600 includes the first device under test (DUT1). The DUT1 is disposed between the reference signal generator and the comparator 506 (not shown in Figure 6). For example, the reference signal is applied at input X1 of the DUT1. Further, the DUT1 output may be coupled to the comparator 506 using, for example, a capacitor C1, a transistor S1 and other circuitry as shown. Similarly, a second branch of the first stage 600 includes a second device under test (DUT2). The reference signal is applied at input X2 of the DUT2. Further, the DUT2 may be coupled to the comparator 506 using a capacitor C2, a transistor S2 and other circuitry as shown.

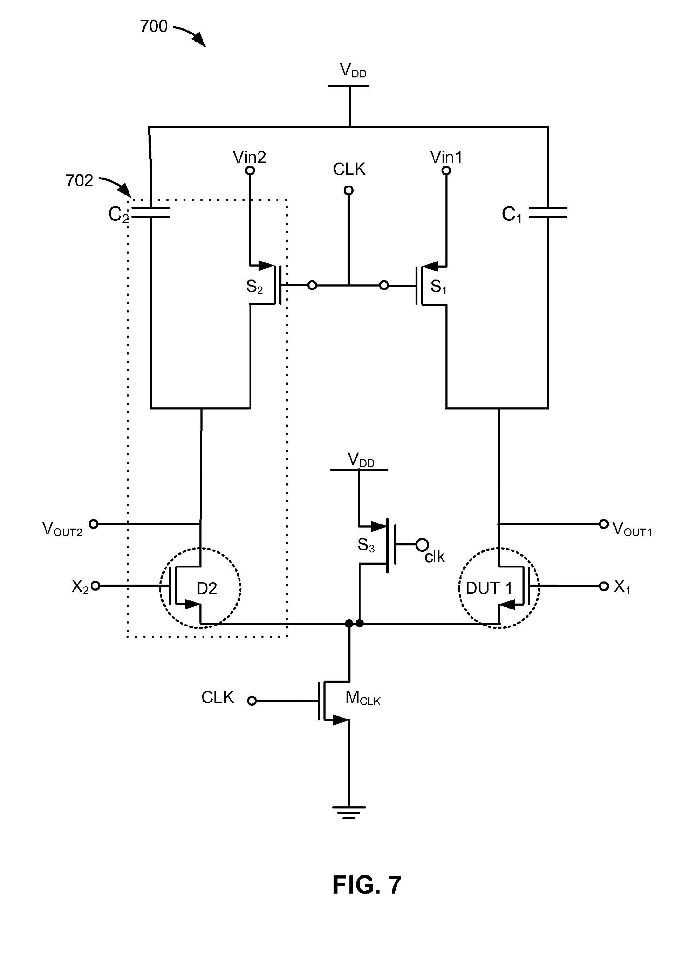

Figure 7 illustrates a first stage 700 of a system for measuring the low frequency noise of a single DUT (for example, DUT1), according to an embodiment of the present disclosure. In this case, the device under test (DUT1) and a second device (D2) form the two branches of the first stage 700. Further, one branch of the input stage 700 is sized up by a factor of N so that its LFN contribution drops by the factor N. Alternatively, this could also be described as one branch being sized down by the factor N. In the example, the second branch is upsized by N. The value of N is chosen sufficiently large so that only the DUT1 contributes to the overall LFN. In this case, the total LFN value of the two devices approximately equals the LFN value of the single DUT which was not sized up, i.e. the DUT1. For example, if N > 10, only 10% of the total LFN of the pair of the DUTs is contributed by the sized up DUT. In an embodiment, all components of the one side of the comparator that is C2, S2 and DUT2 enclosed in the dotted rectangle 702 are scaled up by the factor N. Further M_{CLK} is scaled up by a factor of (N+1)/2.

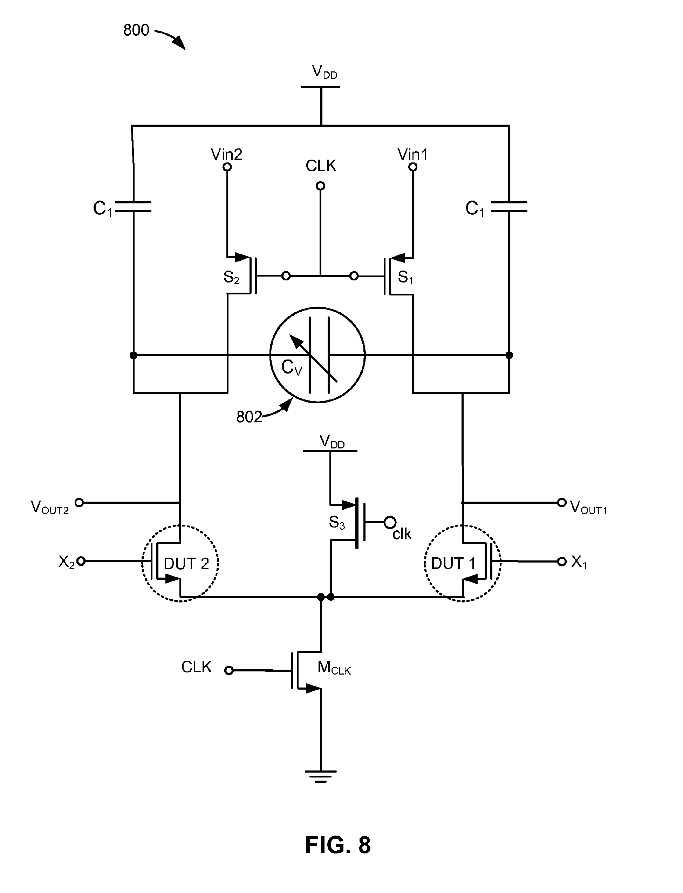

Figure 8 shows a first stage 800 of a system for identifying contribution of the LFN, in accordance with an embodiment of the present disclosure. In this embodiment, a controlled capacitor 802 is connected between outputs of the OUT₁ and the DUT₂. Inclusion of the capacitor 802 makes the DUT stage configurable. The value of the capacitor 802 influences noise gain of the pair of DUTs only. Varying the value of the controlled capacitor 802 enables identification of contribution of the LFN of the DUTs versus LFN component due to other noise sources in the measurement. The value of the capacitor 802 determines how much of the DUT noise is amplified. A large capacitance reduces LFN of the DUTs. The measurement system, according an embodiment of the present disclosure, varies the capacitance value and measures the output at each of the two capacitor values. For example, the measurement system may first set the capacitance of the capacitor 802 at a high value, thereby suppressing the LFN of the DUTs. The measurement system measures the total noise component in the output signal at this capacitance value. The measurement system may then reduce the capacitance to a low value, thereby increasing the contribution of the LFN of the DUTs. This will be reflected in the measured noise component in the output. The measurement system compares the two output measurements to determine whether or not LFN noise of the DUTs is dominant. For example, when the LFN of the DUTs is not dominant, the difference in the measured noise at the output signal may be negligible. Similarly, a significant difference in the measured noise at the output signal may indicate that the LFN of the DUTs is dominant. If the LFN of the DUTs is dominant, then it is determined how much of the measured LFN is due to the DUTs. If the noise of the DUTs is not the dominant signal, an estimate of the noise of the DUTs can be made by comparing a change in output. However, accuracy in the measurement of the LFN is reduced when the LFN due to DUTs is not the dominant component. For example, a 10% increase in overall measured LFN power when the LFN due to the DUTs is on versus off indicates that the LFN due to the DUTs is approximately 1/10 of the measured LFN value.

During design of a measurement system, such as the system 800, simulation checks may be performed to estimate the LFN of the DUTs. Sizes of other devices in the measurement system may be chosen to make the LFN due to DUTs a dominant component. In an embodiment, if the LFN of the DUTs is not measurable, a re-optimized design can be implemented using differently sized comparator stage to lower noise introduced by the other devices. In another embodiment, chopping and/or correlated double sampling techniques may be implemented in comparators to reduce the LFN contribution of the other devices in the comparator.

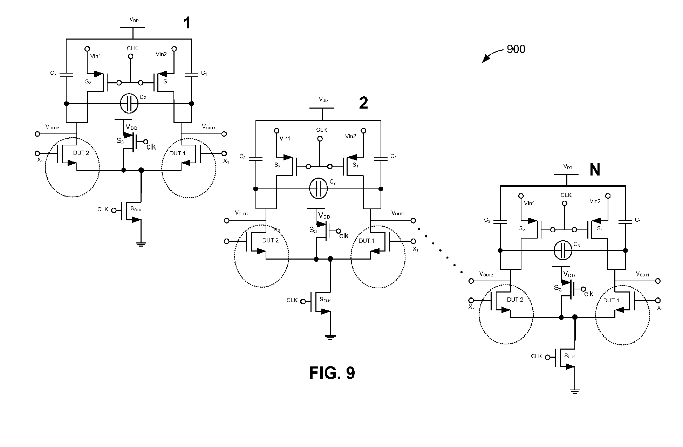

Figure 9 illustrates a system 900 for measuring low frequency noise of a plurality of DUT pairs, in accordance with an embodiment of the present disclosure. The manner of operation of a particular pair of DUTs (for example the pair of DUTs 1) is same as that described in figure 8. In one embodiment, the value of the variable capacitor may be different for each DUT pair. This may allow greater flexibility in controlling the operation of the system 900. In another embodiment, the variable capacitor value may be same for all DUT pairs.

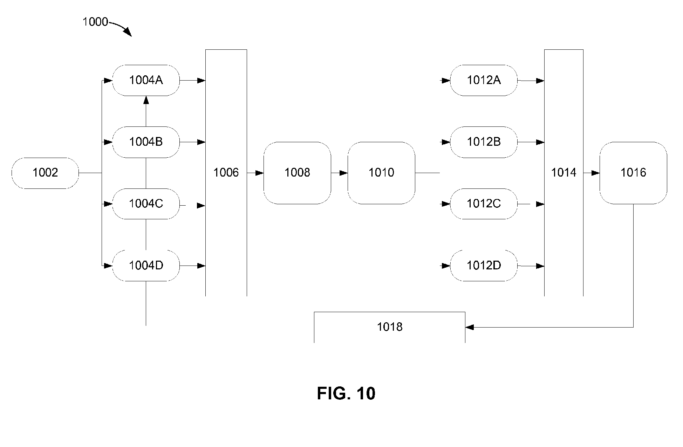

Figure 10 illustrates a system 1000 for measuring low frequency noise of a plurality DUT pairs, in an embodiment of the present disclosure. In the system 1000, the reference signal generator, the digitizing means and the control loop are shared among the plurality of DUT pairs in a multiplexed/interleaved way. The reference signal generator, the digitizing means and the control loop may be implemented using any of the embodiments presented herein. In an example implementation illustrated in Figure 10, the digitizing means is implemented using a comparator and an up/down counter-based integrator. Further, the control loop may be implemented using a DAC according to an example. The arrangement disclosed in the system 1000 reduces the total number of components required on the same wafer to measure the LFN for the plurality of DUTs; thereby saving the space on the wafer and power consumption of the measurement system.

The system 1000 includes a reference signal 1002, a plurality of DUT pairs 1004, a multiplexer 1006, a comparator 1008, an up/down counter 1010, a plurality of memory elements 1012, a multiplexer 1014, and a digital to analog converter (DAC) 1018. One memory element of the plurality of memory elements 1012 corresponds to one pair of DUTs of the plurality of DUT pairs 1004. The multiplexers 1006 and 1014 enable sharing of the comparator 1008, the up/down counter 1010 and the DAC 1018 among the plurality of DUT pairs 1004. For example, a control circuit (not shown) for the multiplexer 1006 may select the DUT pair 1004A and connect the output of the DUT pair 1004A to the comparator 1008 and to the up/down counter 1010 through the comparator 1008. The output of the up/down counter 1010 may be stored in the corresponding memory element 1012A. Further, a control circuit (not shown) of the multiplexer 1014 may select the output of the memory element 1012A and passes the output to the input of the DAC 1018, thus completing the control loop and the measurement for the DUT pair 1004A functions as explained in preceding embodiments. Once the LFN measurement for the DUT pair 1004A is complete, the control circuits for the multiplexer 1006 and the multiplexer 1014 may select the DUT pair 1004B and the memory element 1012B, respectively, and the LFN measurement may be performed for the DUT pair 1004B. This may be continued until the LFN measurement is performed for all DUT pairs. Further, according to an embodiment, the measurement output signals for the DUT pairs 1004 may be stored in respective memory elements 1012 and can be read from the chip later in a time-multiplexed manner by controlling the control circuit of the multiplexer 1010 to serially select the memory elements 1012A, 1012B and so on.

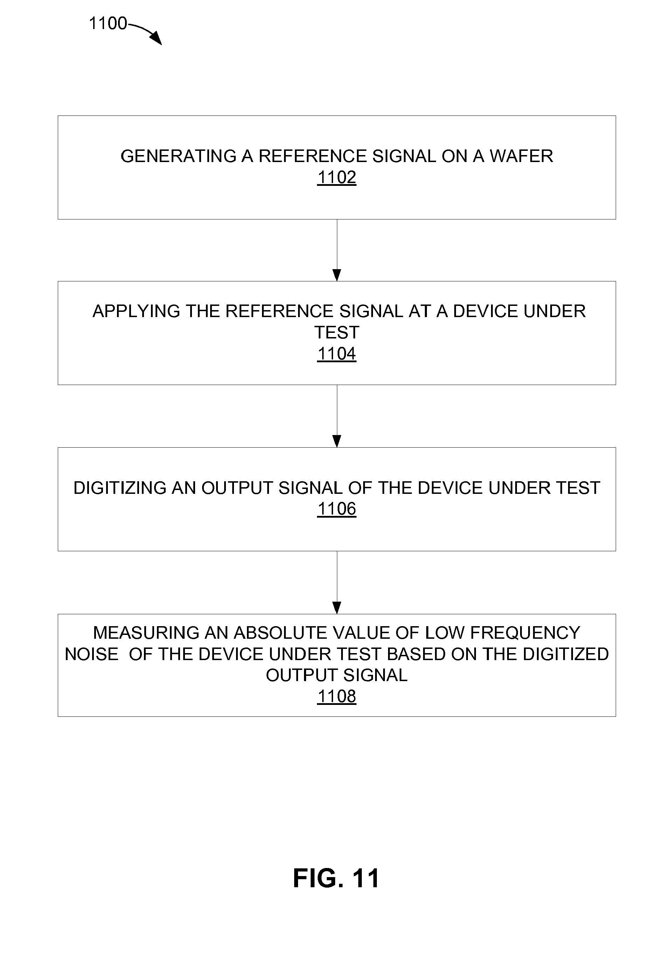

Figure 11 illustrates a method 1100 for measuring low frequency noise due to a device under test according to an embodiment of the present disclosure. The method 1100 begins at step 1102, wherein a reference signal is generated by a reference signal generator. The reference signal generator is disposed on the same wafer as the DUT. Further, the reference signal characteristics (for example, frequency, amplitude, etc.) are predetermined. The reference signal characteristics are set such that the reference signal is dominant over the low frequency noise to be measured. At step 1104, the reference signal is applied to the DUT. The DUT, in response to receiving the applied reference signal generates an output. The output of the DUT comprises the modified reference signal and the low frequency noise of the DUT. At step 1106, the output of the DUT is digitized. The digitization may be performed by any the several mechanisms available in the state of the art. At step 1108, the absolute value of the LFN of the DUT is measured based on the digitized output signal having the reference signal and the low frequency noise signal.

The systems disclosed in the present disclosure may be used to implement a production method for a device under test. The production method includes determining noise characteristics and providing feedback to adjust process conditions. The production method may further include adjusting additional annealing conditions like e.g. temperature, forming gas, and time. The production method may further include step where the feedback is used to modify out-of-spec semiconductor devices to within-target-spec semiconductor devices.

## Claims

1. System for low frequency noise measurement of a device under test on a wafer, comprising:
a reference signal generator connectable to an input of said device under test and provided for generating a predetermined low frequency reference signal;
a digitizing means on the wafer which is connectable to an output of said device under test and provided for digitizing an output signal of the device under test, containing low frequency noise of said device under test and the predetermined reference signal;
wherein the predetermined reference signal is dominant with respect to the low frequency noise of said device under test.

2. System according to claim 1, further comprising a control loop on the wafer, connectable between said digitizing means and said device under test and comprising a control means configured for controlling a component of said device under test on the basis of the digitized output signal, to compensate the low frequency noise.

3. System according to claim 1 or 2, wherein the digitizing means comprises a phase detector and an up/down counter.

4. System according to claim 2 or 3, wherein the control loop comprises a digital-to-analog converter.

5. System according to claim 1, provided for comparing a set of devices under test on the wafer, comprising a first branch wherein a first device under test of the set is connectable between the reference signal generator and the digitizing means and a second branch wherein a second device under test of the set is connectable between the reference signal generator and the digitizing means.

6. System according to claim 5, further comprising an adjustable component connected between the first and second branches and having an adjustable electrical property, such that a ratio of low frequency noise of the first device under test with respect to the second device under test can be adjusted.

7. System according to claim 6, wherein the adjustable component is a capacitor.

8. System according to claim 5, comprising a plurality of said sets of devices under test on the wafer and a corresponding number of sets of said first and second branches, each set of branches having a component which is connected between the first and second branches and has a predefined electrical property which is intentionally different for each set of devices under test.

9. Production method comprising the steps of using the system of any one of the preceding claims for determining noise characteristics and providing feedback to adjust process conditions.

10. Production method according to claim 9, wherein the adjusted process conditions comprise additional annealing conditions.

11. Production method according to claim 9 or 10, wherein the feedback is used to modify out-of-spec semiconductor devices to within-target-spec semiconductor devices.
